# FASCICULE DE BREVET EUROPEEN

(11) **EP 2 368 262 B1**
(45) Date de publication et mention de la délivrance du brevet: **08.03.2017**
(21) Numéro de dépôt: 09797035.4
(22) Date de dépôt: 18.12.2009
(51) Int. Cl.: H01L 21/60, H01L 21/683, H05K 3/32, H01L 21/56, H05K 1/14, H05K 1/18

(54) **PROCEDE DE FABRICATION COLLECTIVE DE MODULES ELECTRONIQUES POUR MONTAGE EN SURFACE**
VERFAHREN ZUR KOLLEKTIVEN HERSTELLUNG VON ELEKTRONIKMODULEN FÜR OBERFLÄCHENANBRINGUNG
METHOD FOR THE COLLECTIVE PRODUCTION OF ELECTRONIC MODULES FOR SURFACE MOUNTING

(30) Priorité: 19.12.2008 FR 0807208
(43) Date de publication de la demande: 28.09.2011
(73) Titulaire: 3D Plus, 78532 Buc Cedex (FR)
(72) Inventeur: VAL, Christian, F-78470 St Remy les Chevreuse (FR); COUDERC, Pascal, F-92000 Nanterre (FR); VAL, Alexandre, F-78150 Roquencourt (FR)
(74) Mandataire: Henriot, Marie-Pierre
(86) Numéro de dépôt international: PCT/EP2009/067530
(87) Numéro de publication internationale: WO 2010/070103

(56) Documents cités:
- EP-A- 1 150 552
- EP-A1- 1 916 709
- WO-A1-2008/105425
- FR-A- 2 864 342
- JP-A- 2004 128 286
- JP-A- 2008 244 191
- US-A- 5 897 336
- US-A1- 2003 022 403
- US-B1- 6 413 851

## Description

Le domaine de l'invention est celui de la fabrication collective de modules électroniques à deux dimensions pour montage en surface aussi dits modules électronique CMS.

Un module électronique comprend un ensemble de composants électroniques connectés à un circuit imprimé aussi désigné PCB acronyme de l'expression anglo-saxonne Printed Circuit Board.

Ces composants électroniques sont :
- des composants passifs 22 de type connecteurs, condensateurs, résistances, transformateurs ou inductances, munis d'éléments de connexion qui sont disposés sur les côtés du corps du composant,
- des composants électromécaniques gravés dans le silicium et connus sous le nom de MEMS (abréviation de l'expression anglo-saxonne « Micro ElectroMechanical Systems »), etc. munis de plots de connexion destinés au montage en surface, ou encore
- des composants électroniques semi-conducteurs autrement appelés composants actifs ou « puces ».

Il est connu d'encapsuler ces composants actifs dans des boîtiers munis de sorties externes, ces boîtiers ayant des dimensions généralement 1,2 à 5 fois plus grandes que la puce nue, la rendant ainsi plus facilement manipulable. La puce nue est connectée à un support lui-même disposé dans le boîtier, le boîtier présentant sa propre connectique externe. L'encapsulation dans les boîtiers permet notamment des procédures de test de la puce, ce qui augmente considérablement le rendement de fabrication des circuits sur lesquels ils sont montés.

Différents types de boîtiers sont connus de l'art antérieur : les boîtiers dits à pattes 24, et les boîtiers dits à billes 23, ou boîtiers BGA (selon l'abréviation de l'expression anglo-saxonne « Ball Grid Array »). Ces boîtiers sont destinés au montage en surface sur un support.

Dans certains cas, ces composants électroniques sont connectés par apport de brasure, la brasure étant généralement constituée d'un alliage métallique de type étain-plomb ou étain-argent-cuivre par exemple. Cependant pour certaines applications, principalement haute température (parapétrolier, motorisation voiture, avion, etc.), la brasure ne convient pas. En effet, la métallurgie de ces alliages fait apparaitre des couches d'intermétalliques. La croissance de ces intermétalliques est activée par la température (loi d'arrhénius). Des mécanismes de vieillissement accélérée des brasures apparaissent, entraînant leur destruction (due par exemple au grossissement des grains, à la diffusion intermétallique, à la formation de composés intermétalliques fragiles, etc.).

Par ailleurs, la multiplication des familles de composants et la raréfaction des boîtiers pour un même composant actif font apparaître une criticité sur les terminaisons des boîtiers. En effet, l'assemblage électronique est d'une hétérogénéité telle que dans certains cas la fiabilité ne peut être atteinte. Par exemple des boîtiers à bille d'alliage SAC105 (Température de fusion Tf=228°C) vont être incompatibles avec des boîtiers de terminaison étain plomb (Tf=186°C) voire étain argent cuivre (SAC305).

Dans d'autres cas, ces composants électroniques sont connectés à un circuit d'interconnexion sans apport de brasure. Un exemple d'un tel procédé d'interconnexion est décrit dans le brevet FR2864342. Il comprend notamment l'assemblage des composants sur un support, les sorties externes des composants faisant face au support. Ce support peut être un support provisoire destiné à être retiré. Le procédé comprend ensuite le dépôt d'une couche de résine sur la face supérieure du support, permettant de mouler les composants et d'assurer leur maintien mécanique, l'ensemble ainsi constitué formant une galette pouvant comprendre un grand nombre de composants agencés selon un nombre donné de motifs identiques, permettant ainsi un procédé collectif. Le procédé comprend ensuite le surfaçage de la galette permettant de faire apparaître sur une surface de connexion sensiblement plane, les sorties externes des composants. Ces sorties sont alors connectées entre elles selon un schéma électrique de connexion prédéterminé, par exemple par photogravure d'une couche métallique. Plusieurs niveaux de métallisation peuvent être effectués si le routage ne peut être fait en un seul niveau. Ce circuit d'interconnexion multi-niveau ou multi-couches est construit sur la galette ; il ne s'agit pas d'un circuit PCB. Dans le cas d'un procédé collectif, la galette est finalement découpée selon les motifs permettant de réaliser autant de dispositifs électroniques pouvant résister à des hautes températures. Ce procédé présente cependant les inconvénients suivants : la complexité d'interconnexion est limitée car il est difficile de réaliser un circuit de plus de 4 couches par une technique de dépôt additive. De plus il est impossible de réparer une galette comportant des composants défectueux moulés.

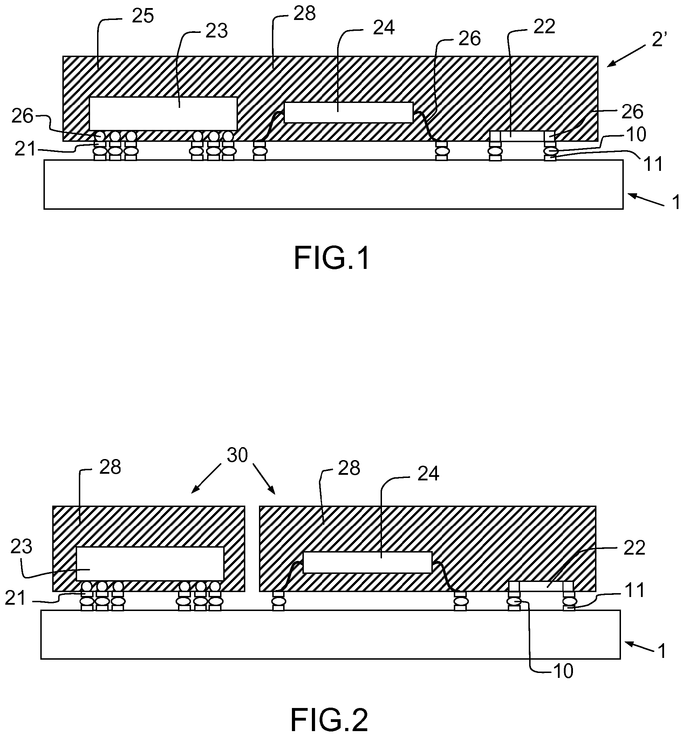

Selon une variante connue illustrée figure 1, la fabrication de la galette 2' et d'un circuit PCB 1 est découplée. Ils sont ensuite connectés l'une à l'autre au moyen d'une colle 10 époxy à base d'argent. Toutefois l'on sait que le collage de composants « étamés » tels que les sorties externes 26, donne lieu à des oxydations en chaleur humide qui peuvent conduire à une interface isolante entre la sortie externe 26 (patte, bille etc...) à base d'étain et la colle 10 à l'argent. Afin de remédier à cela, on sait qu'il faut coller sur des métaux non oxydables. C'est pourquoi, avant cette connexion, les sorties externes 26 de la galette sont recouvertes d'un métal ou d'un alliage peu ou pas oxydable 21 tel que l'or ainsi que les plots du circuit PCB (plots métallisés 11) destinés à être connectés aux sorties externes. Cette variante permet d'utiliser un circuit PCB standard mais il n'est toujours pas possible de réparer des composants défectueux moulés dans une galette.

En conséquence, il demeure à ce jour un besoin pour un procédé de fabrication collective de modules électroniques CMS, donnant simultanément satisfaction à l'ensemble des exigences précitées, à savoir connexion sans apport de brasure, utilisation d'un circuit PCB et possibilité de réparation des composants défectueux moulés dans une galette.

Plus précisément l'invention a pour objet un procédé de fabrication collective de modules électroniques CMS à partir d'une galette à sorties métallisées comportant sur une première face des boîtiers électroniques moulés dans de la résine, chaque boîtier électronique comportant un composant actif monté sur un support, et sur la face opposée, les sorties externes des boîtiers électroniques sur lesquelles est déposé un métal ou un alliage pas oxydable, et d'un circuit imprimé muni de plots en métal ou en alliage pas oxydable.

L'invention pourvoit un procédé selon la revendication 1. Le procédé comprend les étapes suivantes de :
- découpe de la galette selon des motifs prédéterminés permettant d'obtenir des composants moulés reconfigurés, chaque composant moulé reconfiguré comportant au moins un boîtier électronique,
- assemblage des composants moulés reconfigurés sur le circuit imprimé, les sorties externes métallisées des composants moulés reconfigurés étant disposées vis-à-vis des plots du circuit imprimé et,
- connexion sans apport de brasure de ces sorties externes, aux plots métallisés du circuit imprimé au moyen d'un matériau à base à base de colle ou d'encre électriquement conductrice.

Ce procédé offre la possibilité de réparer les composants reconfigurés défectueux, les composants reconfigurés étant obtenus à partir d'une galette.

La galette à sorties métallisées est obtenue selon les étapes suivantes :
- assemblage des boîtiers électroniques sur la face d'un support provisoire telle que la face adhésive d'une peau collante, dite face supérieure, les sorties externes faisant face à cette face supérieure,
- dépôt d'une couche de résine sur la face supérieure, pour mouler les boîtiers électroniques, et ainsi obtenir une galette,
- retrait du support provisoire,
- surfaçage ou attaque au moyen d'un plasma, de la face inférieure de la galette opposée à la face supérieure jusqu'à faire apparaître les sorties externes des boîtiers électroniques et ainsi obtenir une surface plane,
- dépôt du métal ou de l'alliage peu ou pas oxydable que sur ces sorties par masquage ou dépôt du métal ou de l'alliage sur cette surface plane et retrait du métal ou de l'alliage en dehors des sorties externes par gravure chimique ou par laser ou par sablage.

Selon une variante, une attaque au moyen d'un plasma est effectuée pour faire apparaître les sorties externes et la dernière étape de dépôt est effectuée par les étapes suivantes :
- dépôt d'une nourrice métallique sur toute la face inférieure,
- dépôt d'une couche de résine photogravable qui sera photogravée au droit de chaque sortie externe,
- dépôt sélectif de nickel et or qui est réalisé par dépôt électrochimique grâce à la couche de nourrice,
- dissolution de la couche de résine photogravable ainsi que de la couche de nourrice.

D'autres caractéristiques et avantages de l'invention apparaîtront à la lecture de la description détaillée qui suit, faite à titre d'exemple non limitatif et en référence aux dessins annexés dans lesquels :
la figure 1 représente schématiquement une galette connectée à un circuit PCB selon l'état de la technique,
la figure 2 représente schématiquement des composants reconfigurés connectés à un circuit PCB,
les figures 3 illustrent schématiquement un premier mode de réalisation d'une galette à sorties externes métallisées,
les figures 4 illustrent schématiquement un deuxième mode de réalisation d'une galette à sorties externes métallisées ne faisant pas partie de l'invention,
les figures 5 illustrent schématiquement un troisième mode de réalisation d'une galette à sorties externes métallisées ne faisant pas partie de l'invention,
les figures 6 illustrent schématiquement un quatrième mode de réalisation d'une galette à sorties externes métallisées.

D'une figure à l'autre, les mêmes éléments sont repérés par les mêmes références.

Les modules électroniques sont réalisés à partir d'un circuit PCB 1 à plots métallisés 11 et d'une galette 2' à sorties externes métallisées montrés figure 2.

La galette 2' illustrée dans la figure 2 comprend des boîtiers à pattes 24 et/ou des boîtiers à billes 23 et/ou des composants passifs 22 et/ou des MEMS, désignés sous le terme de composants électroniques, moulés dans de la résine 28 ; sur une face de la galette apparaissent les sorties externes 26 de ces composants sur lesquelles est déposé un métal ou un alliage peu ou pas oxydable 21 tel que de l'or ou une couche d'or sur une couche de nickel.

Le circuit PCB 1 comprend généralement plusieurs couches (ou niveaux) de pistes de routage empilées les unes sur les autres, les liaisons entre les pistes des différentes couches étant assurées par des vias métallisés. La couche supérieure destinée à recevoir les composants électroniques comprend en outre des plots destinés à être connectés aux sorties externes des composants. Comme pour les sorties externes, ces plots sont recouverts d'un métal ou d'alliage peu ou pas oxydable tel que de l'or ou une couche d'or sur une couche de nickel. Des éléments de connexion 10 (colle ou encre conductrices par exemple) sont déposés sur les plots métallisés 11 en prévision de leur connexion aux sorties externes métallisées.

Selon l'invention la galette 2' à sorties externes métallisées est découpée en plusieurs parties désignées composants reconfigurés 30 unitaires ou multiples selon qu'ils comportent un ou plusieurs boîtiers électroniques 23, 24. Ces composants reconfigurés 30 qui sont des composants moulés à sorties externes métallisées, sont alors assemblés sur le circuit PCB 1 et connectés par collage par exemple comme illustré figure 2. On a alors obtenu un module électronique CMS apte à réaliser une fonction électronique complète dont on peut réparer les éventuels composants reconfigurés défectueux : il suffit de décoller le composant reconfiguré défectueux pour le réparer.

La connexion sans apport de brasure est obtenue par collage à partir d'une colle 10 thermodurcissable époxy à base d'argent, polymérisée ou plus précisément réticulée, ou thermoplastique à base de particules métalliques non oxydables. Elle peut aussi être obtenue par frittage d'une encre à nano-particules d'argent. Le frittage est la consolidation d'un matériau, obtenue par apport d'énergie, sans aller jusqu'à la fusion. En l'occurrence, le matériau est cette encre qui comprend des nanoparticules d'argent. Sous l'effet de cette énergie, les nanoparticules se soudent entre elles et forment ainsi une liaison mécanique et électrique. Dans ce cas l'encre est déposée sur les plots du circuit PCB.

Le concept de boîtier plastique (un boîtier contient une puce électronique en général) reconfiguré c'est-à-dire comportant des plots dorés et pouvant être collé sur un circuit imprimé standard est extrêmement intéressante. Le collage au moyen d'une colle ou d'une encre électriquement conductrice permet de lier électriquement ces boîtiers reconfigurés au circuit imprimé et ceci à basse température (aux alentours de 100°C°).

Les avantages sur la filière utilisée actuellement dans le monde et concernant la quasi totalité des cartes électroniques sont les suivants:
- La fiabilité des circuits imprimés n'est pas connue avec l'usage des brasures sans plomb car la température de refusion de la brasure a été accrue de 30 à 40°C,
- les équipementiers qui produisent des cartes électroniques sensibles, pour les domaines tels que: la défense, l'aéronautique, l'automobile sont obligés de maintenir la température de refusion des brasures à ce qu'elle était avant la venue des brasures sans plomb de façon à ne pas modifier la fiabilité des dites cartes ; cela les conduit à utiliser l'ancienne brasure contenant de l'étain et du plomb (point de fusion à 183°C) avec les composants ayant des brasures sans plomb. Cette approche pourrait être acceptable après essais pour redéfinir la fiabilité des joints de brasure mais la composition des brasures sans plomb utilisée sur les boîtiers évolue fréquemment. La raison est donnée par l'industrie des téléphones qui fait modifier la composition des brasures sans plomb de façon à satisfaire ses propres besoins. Les besoins portant massivement sur la tenue des joints de brasure lors du choc des téléphones (Drop Test), il a été développé de nombreux alliages ternaires regroupés dans la famille des "SAC" c'est à dire étain, argent et cuivre ; de nouveaux alliages quaternaires apparaissent et en aucun cas ceux-ci ne sont optimisés pour améliorer la fiabilité des brasures. Ce faisant les équipementiers qui souhaitent garantir un niveau de fiabilité ne peuvent le faire.

- l'ensemble des équipements de montage en surface sont utilisables sans modifications:
- sérigraphie de colle au lieu de la pate à braser classique,
- report automatique des composants reconfigurés exactement comme les composants standards,
- four de polymérisation identique au four de refusion utilisé pour la pate à braser mais à plus basse température: 100°C par exemple au lieu de 250-260°C avec les brasures sans plomb.

Pour toutes ces raisons, le collage des boîtiers reconfigurés de façon à avoir des plots dorés, sur des circuits imprimés qui déjà disposaient de plots dorés, conduit à une filière fiable (et même plus fiable puisque les circuits imprimés ne verront qu'une température très faible comparée à ce qu'elle était avec la filière standard avec plomb soit 220°C) tout en utilisant les importants moyens industriels existant déjà.

La galette 2' à sorties externes métallisées peut être obtenue de différentes façons.

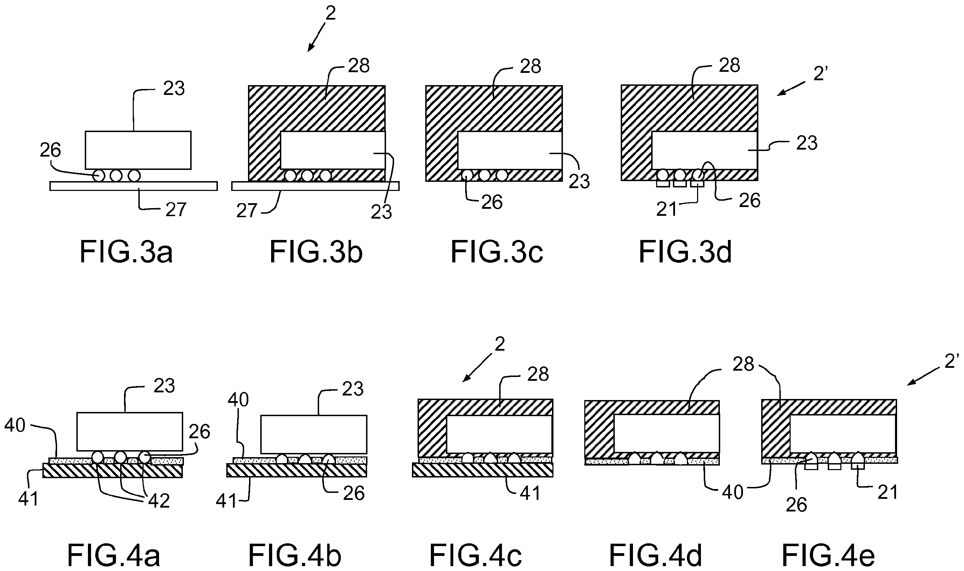

Selon un premier mode de réalisation selon l'invention et décrit en relation avec les figures 3, la réalisation de la galette 2' comporte les étapes suivantes :
- assemblage des composants électroniques (boîtiers 23, 24) sur la face supérieure d'un support provisoire telle que la face collante d'une feuille adhésive 27 aussi désignée peau collante (figure 3a),
- dépôt d'une couche de résine 28 sur la face supérieure, pour mouler les composants 23, 24 et assurer le maintien mécanique des composants entre eux (figure 3b). Il s'agit d'un dépôt par exemple de résine Epoxy (naturellement polymérisée), à haute température si nécessaire, à réaliser au-dessus de ces composants afin de les recouvrir (éventuellement partiellement) et de former une galette 2 qui peut comprendre un nombre donné de motifs identiques.
- retrait du support provisoire 27 (figure 3c), par exemple par pelage de façon à faire apparaître l'extrémité de toutes les sorties externes 26 qui apparaissent, (pattes, billes ou plots de tous les composants reportés en surface),
- surfaçage par polissage pour « rafraîchir » les connexions en supprimant des éventuelles couches d'oxyde, sulfure ou chlorure, et pour faire apparaître une plus grande surface de connexion lorsque les sorties externes sont des billes,
- dépôt du métal ou de l'alliage pas oxydable 21 que sur ces sorties externes 26 (figure 3d) par voie liquide ou par voie gazeuse ou par voie solide sur cette surface plane et retrait du métal ou de l'alliage en dehors des sorties externes par gravure chimique ou par laser ou par sablage.

Ce premier mode de réalisation présente des inconvénients lorsqu'il y a des composants passifs 22 parmi les composants reportés en surface sur la peau collante. En effet lors du surfaçage, le composant passif est détérioré car du fait de sa configuration géométrique montrée figures 1 et 2, le corps du composant 22 qui est en contact avec la peau collante, est également poli. Les modes de réalisation suivants permettent de préserver l'intégrité des composants passifs.

Selon un deuxième mode de réalisation ne faisant pas partie de l'invention et décrit en relation avec les figures 4, la réalisation de la galette 2' comporte les étapes suivantes :
- dépôt d'un vernis 40 sur une plaque de cuivre 41 d'une épaisseur comprise entre 25 et 100 µm, sauf sur des zones 42 destinées à recevoir les sorties externes des composants électroniques,
- report des composants électroniques 22, 23, 24 sur cette plaque de cuivre 41 (figure 4a) manière à faire coïncider les sorties externes 26 avec ces zones 42 sans vernis, et brasure (figure 4b) de ces sorties 26 à la plaque de cuivre 41 au moyen d'une pâte à braser ; pendant cette brasure, les billes fondent de sorte que la surface de la bille en contact avec le cuivre est quasiment celle de sa section diamétrale soit environ 200 µm,
- dépôt d'une couche de résine 28 sur cette plaque de cuivre vernie (figure 4c), pour mouler les composants et assurer le maintien mécanique des composants entre eux. Il s'agit d'un dépôt par exemple de résine époxy (naturellement polymérisée), à haute température si nécessaire, à réaliser au-dessus de ces composants afin de les recouvrir éventuellement partiellement et de former une galette qui peut comprendre un nombre donné de motifs identiques,
- retrait du cuivre 41 par dissolution (figure 4d),
- dépôt du métal ou de l'alliage peu ou pas oxydable 21 sur les sorties externes (figure 4e) par voie liquide ou par voie gazeuse ou par voie solide ne laissant apparaître que ces sorties 26 ou dépôt sur toute la surface plane et retrait du métal ou de l'alliage en dehors des sorties externes par gravure chimique ou par laser ou par sablage.

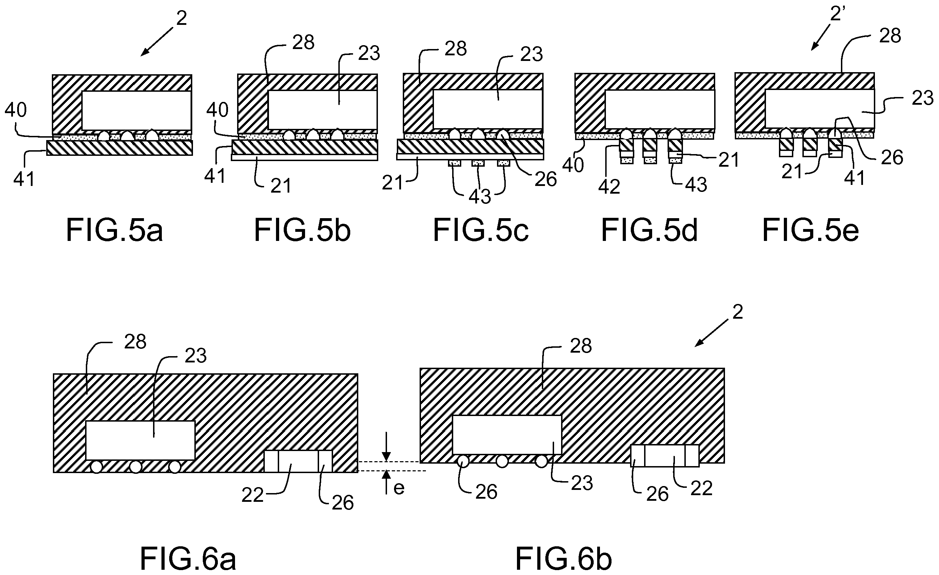

Selon un troisième mode de réalisation ne faisant pas partie de l'invention et décrit en relation avec les figures 5, la réalisation de la galette 2' comporte les étapes suivantes :
- dépôt d'un vernis 40 sur une plaque de cuivre 41 d'une épaisseur comprise entre 25 et 100 µm, sauf sur des zones 42 destinées à recevoir les sorties externes des composants électroniques,
- assemblage des composants électroniques 22, 23, 24 sur cette plaque de cuivre 41 (sur la face avec vernis) de manière à faire coïncider les sorties externes 26 avec ces zones 42 sans vernis, et brasure de ces sorties 26 à la plaque de cuivre au moyen d'une pâte à braser, comme pour le mode de réalisation précédent, comme illustré figures 4a et 4b,
- dépôt d'une couche de résine 28 sur cette plaque de cuivre vernie, pour mouler les composants et assurer le maintien mécanique des composants entre eux comme dans le mode de réalisation précédent, comme illustré figures 5a,
- dépôt du métal ou de l'alliage peu ou pas oxydable 21 sur le cuivre sur toute la face opposée de cette plaque de cuivre 41 (figure 5b),
- dépôt sur le métal ou l'alliage, d'un vernis 43 photogravable ou non sur des zones à l'aplomb des sorties externes 26 en vue de les protéger lors de l'étape suivante (figure 5c),
- retrait du métal ou de l'alliage 21 et du cuivre 41 en dehors de ces zones protégées, par exemple par dissolution, de manière à dégager les sorties métallisées vernies qui comportent à ce stade un empilement de cuivre, de métal ou d'alliage peu ou pas oxydable et de vernis sur les sorties externes (figure 5d),
- retrait du vernis 43 de ces zones, c'est-à-dire de ces sorties vernies par exemple par dissolution chimique de manière à obtenir des sorties métallisées (figure 5e) qui comportent un empilement de cuivre 41 et métal ou alliage peu ou pas oxydable 21 sur la sortie externe 26 d'origine.

Selon un quatrième mode de réalisation selon l'invention et décrit en relation avec les figures 6, la réalisation de la galette 2' comporte les étapes suivantes :
- assemblage des composants électroniques sur la face d'un support provisoire telle que la face adhésive d'une peau collante dite face supérieure comme illustré figure 3a,
- dépôt d'une couche de résine sur cette face supérieure comme illustré figure 3b, pour mouler les composants et assurer le maintien mécanique des composants entre eux comme dans le mode de réalisation précédent,
- retrait du support provisoire comme illustré figure 3c, par exemple par pelage de façon à faire apparaître l'extrémité de toutes les sorties externes qui apparaissent, (pattes, billes ou plots de tous les composants reportés en surface),
- attaque de la face laissée libre par le retrait du support provisoire, au moyen d'un plasma (figure 6a) tel qu'un mélange d'oxygène et de fluorure de carbone (O₂+CF₄), pour dégager les sorties externes 26 de la résine 28 sur une épaisseur e comprise entre 10 et 100 µm. Le plasma attaque la résine époxy 28, les billes en silice situées dans cette résine mais il n'attaque pas les métaux des billes des pattes et des plots des composants passifs (figure 6b),
- dépôt du métal ou d'un alliage pas oxydable 21 que sur ces sorties 26 comme illustré figure 3d, par masquage ou dépôt du métal ou de l'alliage sur cette surface plane et retrait du métal ou de l'alliage en dehors des sorties externes par gravure chimique ou par laser ou par sablage.

Selon un cinquième mode de réalisation selon l'invention la réalisation de la galette 2' comporte les mêmes étapes que celles décrites pour le quatrième mode de réalisation, la dernière étape de dépôt du métal étant remplacée par les étapes suivantes :
- dépôt d'une nourrice métallique (« seed layer » en anglais) sur toute la face inférieure,
- dépôt d'une couche de résine photogravable qui sera photogravée au droit de chaque sortie externe 26,
- dépôt sélectif de nickel et or qui est réalisé par dépôt électrochimique grâce à la couche de nourrice,
- la couche de photoresist c'est-à-dire de résine photogravable est ensuite dissoute ainsi que la couche de nourrice.

## Revendications

1. Procédé de fabrication collective de modules électroniques CMS selon les étapes suivantes :
- fabrication d'une galette (2') qui comprend les sous-étapes suivantes :
i. assemblage sur la face d'un support provisoire (27) dite face supérieure, de boîtiers électroniques (23, 24), un boîtier électronique comportant un composant actif connecté à un support, cet ensemble étant encapsulé et pourvu de sorties externes (26), ces sorties externes (26) faisant face à cette face supérieure,
ii. dépôt d'une couche de résine (28) sur la face supérieure, pour mouler les boîtiers électroniques (23, 24), et ainsi obtenir une galette (2),
iii. retrait du support provisoire (27),
iv. surfaçage ou attaque au moyen d'un plasma, de la face inférieure de la galette (2) opposée à la face supérieure, pour faire apparaître les sorties externes (26),
v. dépôt du métal ou de l'alliage pas oxydable (21) que sur ces sorties externes (26) par masquage ou dépôt du métal ou de l'alliage (21) sur cette surface munie des sorties externes et retrait du métal ou de l'alliage en dehors des sorties externes (26) par gravure chimique ou par laser ou par sablage,
- fabrication d'un circuit imprimé (1) muni de plots (11) en métal ou en alliage pas oxydable,
- découpe de la galette (2') selon des motifs prédéterminés permettant d'obtenir des composants moulés reconfigurés (30), chaque composant moulé reconfiguré comportant au moins un boîtier électronique,
- assemblage des composants moulés reconfigurés (30) sur le circuit imprimé (1), les sorties externes métallisées des composants moulés reconfigurés étant disposées vis-à-vis des plots métallisés (11) du circuit imprimé et,
- connexion sans apport de brasure de ces sorties externes, aux plots métallisés du circuit imprimé au moyen d'un matériau (10) à base de colle ou d'encre électriquement conductrice.

2. Procédé selon la revendication 1, **caractérisé en ce que** l'étape iv consiste en l'attaque au moyen d'un plasma de la face inférieure de la galette (2) opposée à la face supérieure, et l'étape v de dépôt est effectuée selon les sous-étapes suivantes :
- dépôt d'une nourrice métallique sur toute la face inférieure,
- dépôt d'une couche de résine photogravable qui sera photogravée au droit de chaque sortie externe (26),
- dépôt sélectif de nickel et or qui est réalisé par dépôt électrochimique grâce à la couche de nourrice,
- dissolution de la couche de résine photogravable ainsi que de la couche de nourrice.

3. Procédé selon l'une des revendications précédentes, **caractérisé en ce que** pour l'étape i, des composants passifs (22) à sorties externes (26) sont également assemblés sur la face du support provisoire (27) et moulés lors de l'étape ii.

4. Procédé selon l'une des revendications 1 ou 3, **caractérisé en ce que** le métal ou l'alliage pas oxydable (21) est de l'or ou une couche d'or sur une couche de nickel.

## Patentansprüche

1. Verfahren zur kollektiven Herstellung von elektronischen Modulen CMS gemäß den folgenden Schritten:
- Herstellen eines Wafers (2'), das die folgenden Teilschritte beinhaltet:
i. Zusammenfügen, auf der Fläche eines provisorischen Trägers (27), obere Fläche genannt, von elektronischen Bauelementen (23, 24), wobei ein elektronisches Bauelement eine mit einem Träger verbundene aktive Komponente umfasst, wobei die genannte Baugruppe verkapselt und mit externen Ausgängen (26) versehen ist, wobei die genannten externen Ausgänge (46) der genannten oberen Fläche zugewandt sind;
ii. Absetzen einer Harzschicht (28) auf der oberen Fläche, um die elektronischen Bauelemente (23, 24) zu vergießen und so einen Wafer (2) zu erhalten;
iii. Entfernen des provisorischen Trägers (27);
iv. Oberflächenbehandeln oder Ätzen, mittels eines Plasmas, der unteren Fläche des Wafers (2) gegenüber der oberen Fläche, um die externen Ausgänge (26) zu exponieren;
v. Absetzen des/der nicht oxidierenden Metalls oder Legierung (21) nur auf den genannten externen Ausgängen (26) durch Maskieren oder Absetzen des Metalls oder der Legierung (21) auf der genannten mit den externen Ausgängen versehenen Oberfläche und Entfernen des Metalls oder der Legierung aus den externen Ausgängen (26) durch chemisches Ätzen oder durch Lasern oder durch Sandstrahlen,
- Herstellen einer gedruckten Schaltung (1), die mit Kontaktstellen (11) aus nicht oxidierendem/r Metall oder Legierung versehen ist;
- Schneiden des Wafers (2') gemäß vorbestimmten Mustern, so dass umkonfigurierte vergossene Komponenten (30) erhalten werden können, wobei jede umkonfigurierte vergossene Komponente wenigstens ein elektronisches Bauelement umfasst;
- Zusammenfügen der umkonfigurierten vergossenen Komponenten (30) auf der gedruckten Schaltung (1), wobei die metallisierten externen Ausgänge der umkonfigurierten vergossenen Komponenten gegenüber den metallisierten Kontaktstellen (11) der gedruckten Schaltung angeordnet sind; und
- Verbinden, ohne Verlöten, der genannten externen Ausgänge mit den metallisierten Kontaktstellen der gedruckten Schaltung mit Hilfe eines Materials (10) auf der Basis von elektrisch leitendem/r Klebstoff oder Tinte.

2. Verfahren nach Anspruch 1, **dadurch gekennzeichnet, dass** Schritt iv das Ätzen der unteren Fläche des Wafers (2) gegenüber der oberen Fläche mittels eines Plasmas beinhaltet und Schritt v des Absetzens gemäß den folgenden Teilschritten ausgeführt wird:
- Absetzen eines metallischen Verteilers auf der gesamten unteren Fläche;
- Absetzen einer Schicht aus fotoätzbarem Harz, die fotogeätzt werden wird, an jedem externen Ausgang (26);
- selektives Absetzen von Nickel und Gold, das durch elektrochemische Abscheidung dank der Verteilerschicht erfolgt;
- Auflösen der Schicht aus fotoätzbarem Harz sowie der Verteilerschicht.

3. Verfahren nach einem der vorherigen Ansprüche, **dadurch gekennzeichnet, dass** für Schritt i passive Komponenten (22) mit externen Ausgängen (26) ebenfalls auf der Fläche des provisorischen Trägers (27) zusammengefügt und während Schritt ii vergossen werden.

4. Verfahren nach einem der Ansprüche 1 oder 3, **dadurch gekennzeichnet, dass** das/die nicht oxidierbare Metall oder Legierung (21) Gold oder eine Goldschicht auf einer Nickelschicht ist.

## Claims

1. A method for the collective manufacture of electronic modules CMS according to the following steps:
- manufacturing a wafer (2'), which comprises the following sub-steps:
i. assembling, on the face of a provisional support (27) called upper face, electronic units (23, 24), an electronic unit comprising an active component connected to a support, said assembly being encapsulated and provided with external outputs (26), said external outputs (26) facing said upper face;
ii. depositing a layer of resin (28) on the upper face in order to mould the electronic units (23, 24) and thus obtain a wafer (2);
iii. withdrawing the provisional support (27);
iv. dressing or etching, by means of a plasma, the lower face of the wafer (2) opposite the upper face, so as to reveal the external outputs (26);
v. depositing the non-oxidising metal or alloy (21) only on said external outputs (26) by masking or depositing the metal or alloy (21) on said surface provided with the external outputs and withdrawing the metal or alloy out of the external outputs (26) by chemical etching or by laser or by sand blasting,
- manufacturing a printed circuit (1) provided with pads (11) made of non-oxidising metal or alloy;
- cutting the wafer (2') according to predetermined patterns that allow reconfigured moulded components (30) to be obtained, each reconfigured moulded component comprising at least one electronic unit;
- assembling the reconfigured moulded components (30) on the printed circuit (1), the metallised external outputs of the reconfigured moulded components being arranged opposite the metallised pads (11) of the printed circuit; and
- connecting, without adding solder to said external outputs, to the metallised pads of the printed circuit by means of a material (10) based on electrically conductive glue or ink.

2. The method according to claim 1, **characterised in that** step iv comprises etching the lower face of the wafer (2) opposite the upper face by means of a plasma and step v of depositing is carried out using the following sub-steps:
- depositing a metallic manifold over the entire lower face;
- depositing a layer of photo-etchable resin that will be photo-etched at each external output (26);
- selectively depositing nickel and gold, which is carried out by electrochemical depositing by virtue of the manifold layer;
- dissolving the layer of photo-etchable resin, as well as the manifold layer.

3. The method according to any one of the preceding claims, **characterised in that**, for step i, passive components (22) with external outputs (26) are also assembled on the face of the provisional support (27) and are moulded during step ii.

4. The method according to claim 1 or 3, **characterised in that** the non-oxidising metal or alloy (21) is gold or a layer of gold on a nickel layer.
